Europäisches Patentamt

European Patent Office

Office européen des brevets

(19)

(11) Publication number: **0 023 528**
**A1**

(12) **EUROPEAN PATENT APPLICATION**

(21) Application number: **79302785.5**

(22) Date of filing: **04.12.79**

(51) Int. Cl.³: **H 01 L 29/78, H 01 L 21/18,**
**H 01 L 29/08**

(30) Priority: **04.12.78 US 965796**

(43) Date of publication of application: **11.02.81**
**Bulletin 81/6**

(84) Designated Contracting States: **BE CH DE FR IT NL SE**

(71) Applicant: **MOSTEK CORPORATION, 1215 West Crosby**
**Road, Carrollton Dallas, Texas 75006 (US)**

(72) Inventor: **Chan, Tsiu Chiu, 1622 Camaro Drive, Carrollton**
**Dallas, Texas (US)**
Inventor: **Gosney, William Milton, Route 7 Box 204,**
**McKinney, Texas (US)**

(74) Representative: **Broome, Geoffrey Edward et al,**
**KILBURN & STRODE 30 John Street, London, WC1N 2DD**
**(GB)**

(54) **Double diffused transistor structure and method of making same.**

(57) The invention provides a method for making a metal oxide semiconductor transistor structure in which first regions (52, 54) of a first conductivity type and doped more heavily than the semiconductor substrate (12) of the first conductivity type include second regions (56, 58) of a second conductivity type to form transistor elements. The second regions (56, 58) are of high concentration, and the first region (52, 54) extending beyond and surrounding each second region is preferably of an impurity concentration intermediate than of the substrate (12) and the second region.

The invention also provides a transistor made by such method.

The present invention relates generally to metal-oxide semiconductor transistors, and more particularly to field-effect transistors for use in large scale integrated circuits.

The integrated circuit art strives for improvements in processing technique for reducing the size of the circuit elements and improving device yields. The present invention is directed to a number of related problems inherently involved in making high desnity integrated circuits. In particular, a greater packing density is desired which correspondingly results in greater speed of operation. The usual method has been to scale down the transistor geometries as well as the structure. This has included thinning the gate oxide and increasing the substrate concentration.

The present invention achieves a smaller geometry without the usual handicap of a high body effect and high parasitic capacitance found in scale down processes. While normal techniques increase the concentration in the channel, thereby increasing body effect, the present invention keeps the concentration within the channel the same while decreasing the channel length. This is achieved by a high doping of the region surrounding the transistor source and drain sites which results in a lower body effect and a lower parasitic capacitance. Further, the device performance is less device-length dependent, and threshold voltage is controlled by accurate impurity implantation rather than being dependent on substrate material and concentration. Therefore, the length of the channel becomes less critical due to the high concentration of the copants thereby requiring less accuracy

2.                    0023528

in manufacturing.

Accordingly the present invention provides a metal oxide semiconductor transistor structure comprising a semiconductor substrate of a first conductivity type; a first insulating layer on a major surface of the semiconductor substrate; two first regions of the first conductivity type disposed in the substrate and doped more heavily than the substrate; two second regions of a second conductivity type, each disposed in the substrate within a first region and doped more heavily than the first region; a channel region of the first conductivity type disposed in the substrate between the second regions and including a portion of the first regions; and a conductive gate disposed on the insulating layer and aligned over the channel region due to the placement of the first and second regions.

According to a further aspect the invention provides a metal oxide semiconductor transistor structure comprising a semiconductor substrate of a first conductivity type having an impurity concentration of below $3 \times 10^{15}$ atoms per $cm^3$; a first insulating layer disposed on a major surface of the semiconductor substrate; two first regions of the first conductivity type disposed in the substrate and having an impurity concentration of between $10^{15}$ atoms per $cm^3$ and $10^{17}$ atoms per $cm^3$; two second doped regions of a second conductivity type each disposed in the substrate within a first region and having an impurity concentration above $10^{19}$ atoms per $cm^3$; a channel region of the first conductivity type disposed in the substrate between the second regions and including portions of the first regions; and a conductive gate disposed on the insulating layer and aligned over the channel region.

According to a further aspect the invention provides a method for making a metal oxide semiconductor transistor structure comprising the steps of providng a semiconductor substrate of a first conductivity type; forming a first insulating layer of silicon dioxide on an active surface of the substrate; forming a second insulating layer of silicon nitride on the first insulating layer; placing a photoresistive mask over the second insulating layer to define selected areas; removing said selected areas of the photoresistive mask by a photographic technique to expose the second insulating layer below the selected area; etching the exposed areas of the second insulating layer; implanting ions of the first conductivity type through the exposed regions; growing thick oxide regions over the implanted regions; removing the remaining second insulating layer; removing the first insulating layer; growing a thin oxide insulating layer; depositing a polysilicon layer on a thin oxide insulating layer; removing portions of the polysilicon layer to define a conductive gate; implanting ions of the first conductivity type in the areas between the conductive gate and thick oxide regions; diffusing the implanted ions to form first regions; implanting ions of a second conductivity type in the same areas between the conductive gate and thick oxide regions; and diffusing the implanted ions of the second conductivity type to form second regions within the first region.

According to a further aspect the invention provides a method for making a metal oxide semiconductor transistor structure comprising steps of forming a thin oxide insulating layer over a semiconductor substrate; defining a conductive gate on the insulating layer; forming first regions of a first conductivity type on both sides of the conductive gate; and forming second regions of a second conductivity type within the first regions.

According to yet a further aspect the invention provides a method for making a metal oxide semiconductor transistor structure comprising the steps of defining an active area in a semiconductor substrate of a first conductivity type; growing an insulating oxide layer over the active area; forming a conductive gate over the insulating layer; forming first and second regions of different conductivity types on both sides of the conductive gate, the second regions being disposed within the first regions whereby a source and drain are formed.

The present invention thus may increase the packing density in an integrated circuit without increasing the body effect and parasitic capacitance found in any integrated circuit. Under the present invention, a short channel transistor may be constructed having electrical characteristics only moderately dependent on channel length. Further, threshold voltage is less dependent on the substrate material and is controlled by an accurate implantation of the impurities. These desirable characteristics are achieved by a double diffusion process of two different conductivity types.    A first region is of the same conductivity type as the substrate though of a greater concentration and further includes the second region of the second conductivity type which has a heavily doped impurity.    The second regions form the transistor source and drain sites.

BRIEF DESCRIPTION OF THE DRAWINGS

FIGURES 1 - 20 are schematic sectional views illustrating portions of a metal oxide semiconductor transistor at various stages in a process for making the device;

FIGURE 21 is an enlarged view similar to the view of FIGURE 20 illustrating a step in the process; and

FIGURE 22 is a schematic sectional view illustrating the invention at a final stage in the process.

DESCRIPTION OF THE PREFERRED EMBODIMENTS

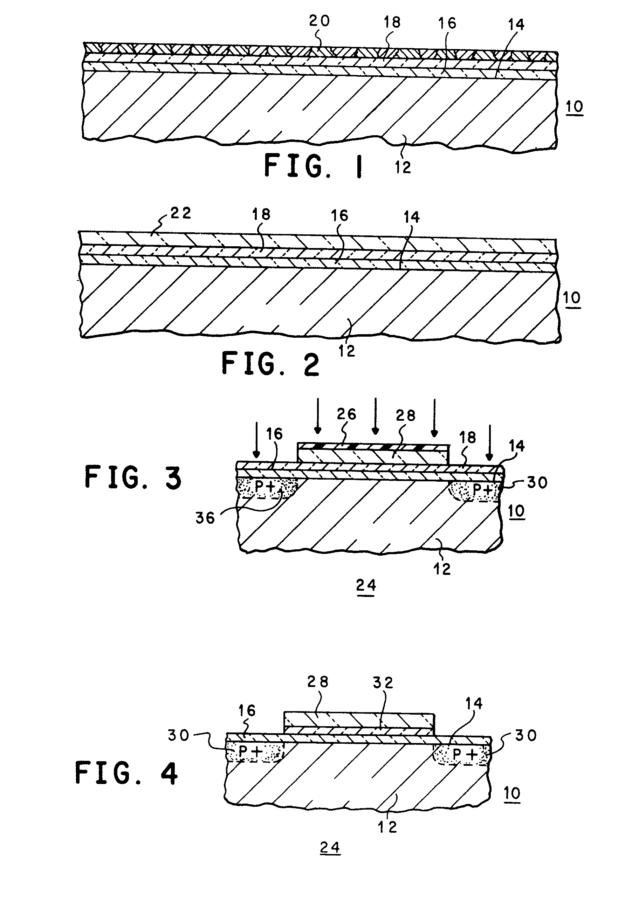

Referring now to FIGURE 1 there is shown a cross-section of a portion of an integrated circuit metal oxide semiconductor transistor structure of the present invention, indicated generally by the reference numeral 10, at an early stage in a manufacturing process.  The device 10 comprises the substrate 12 which is typically monocrystalline silicon of a conventional crystal orientation known in the art.  Many features of the present invention are applicable to devices employing semiconductor materials other than silicon, as will be appreciated by those skilled in the art.  The substrate 12 may be either P-type or N-type; however, for purposes of this illustrative embodiment, P-type conductivity with a concentration of about $2 \times 10^{14}$ to $3 \times 10^{15}$ atoms per $cm^3$ is employed, a preferred resistivity being about 5 to 100 ohm-cm in the substrate 12. Thermally grown on top surface 14 of the substrate 12 is a silicon dioxide layer 16, having a preferred thickness of about 600 Angstroms.  A silicon nitride layer 18, having a preferred thickness of about 600 Angstroms, is deposited on thermal oxide layer 16 in a reactor in a known manner. A top layer 20 of polysilicon having a thickness of about 1000 Angstroms is deposited on nitride layer 18 using known deposition techniques.

The device 10 is then exposed to an oxidizing ambient preferably in steam between about $900^{\circ}C$ to $1000^{\circ}C$ for a sufficient period of time to completely oxidize the polysilicon layer 20 of FIGURE 1, thereby producing a polyoxide layer 22 as shown in FIGURE 2. The polyoxide layer 22 is about 2000 Angstroms thick which is about twice the thickness of the original polysilicon 20 due to growth during oxidation. Referring to FIGURE 3, a representative portion 24 of device 10 is shown after several intermediate steps have been performed. While a distinct component segment or element site 24 is explicitly illustrated in FIGURE 3, it is to be understood that it is representative of a great many similar sites (not shown) wherein similar elements are simultaneously produced in accordance with the description of the inventive process which follows. At site 24, photoresist pattern 26 has been deposited on polyoxide layer 22 using standard photomasking techniques, after which the unmasked portions of layer 22 are etched away using an etchant which selectively attacks the oxide thereby leaving polyoxide portion 28 as shown. Following the etching step, an ion implant step is performed in a known manner as indicated by the arrow, preferably using boron, to produce $P^+$ regions 30, which penetrate to a depth of about 2000 Angstroms in the portions of the substrate 12 not covered by polyoxide (also referred to as the "field area" of the device 10). The energy of the ions is selected so as to penetrate only through the portions of layers 16 and 18 not covered by photoresist and polyoxide. An intensity of about $1.6 \times 10^{13}$ boron ions/cm$^2$ at 50 kev (kilo electron volts) is preferably used in accordance with known techniques as, for example, by means of the techniques described in U. S. Patent No. 3,898,105, hereinafter cited as Mai et al. Whatever technique is used, however, it is preferred that $P^+$ regions 36 have a resistivity of about one ohm-cm in the areas of highest impurity concentration in the final device.

Next, the photoresist layer 26 is removed and the portions of the nitride layer 18 not covered by the polyoxide layer portion 28 is selectively etched away using known techniques, thereby leaving nitride portion 32 as shown in FIGURE 4.

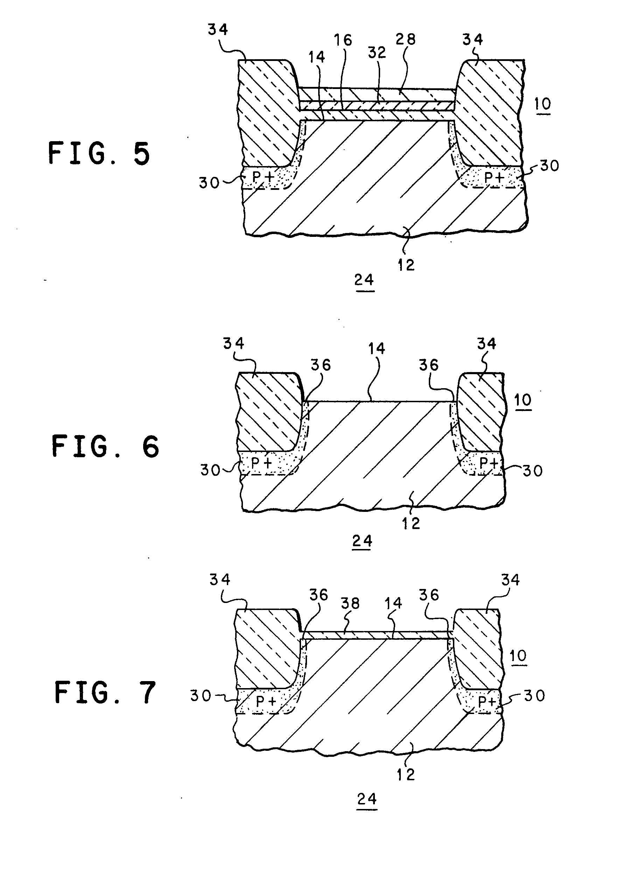

Now referring to FIGURE 5, an oxidation is performed in steam for about 6 to 8 hours at approximately 1000°C, which results in the growth of a relatively thick "isoplanar field oxide" layer 34, preferably of about 14,000 Angstroms in thickness, in the portion of the substrate 12 not covered by silicon nitride. The field oxide 34 penetrates into the substrate 12 to a depth of about 7000 Angstroms, the oxidation process driving the boron implant regions 30 to a greater depth therebelow. The $P^+$ regions 30 permit the use of a thinner field oxide 34 by reducing the resistivity thereunder.

Next, the polyoxide layer 28 is removed by means of etching with hydrofluoric acid in a known manner, which also slightly reduces the thickness of the field oxide 34. Then, the nitride layer 32 and the remaining portions of oxide layer 16 are removed using conventional techniques, which produces the structure shown in FIGURE 6.

Various surface "cleaning" steps are ordinarily used at this point in prior art processes to remove surface damage in the active area of the device. "Active area" means those portions of the device where no field oxide has been grown. It has been found, however, that merely cleaning by etching some of the substrate 12 along surface 14 is inadequate to remove silicon nitride contamination which exists along edges 36 of the substrate 12 near the field oxide 34. Small amounts of silicon nitride from layer 32 are transported to the substrate 14 at the edges of the field oxide 34 incident to the chemical process which produces the field oxide 34. Accordingly, an oxidation step is performed, preferably in an ambient atmosphere of hydrogen chloride and oxygen, to provide thermal oxide layer 38 as shown in FIGURE 7, thereby converting or oxidizing the nitride impurities at edges 36 from the substrate 12 into the oxide as it grows. A thickness of about 300 Angstroms is sufficient for oxide layer 38, with a preferred thickenss being between 300 and 1000 Angstroms.

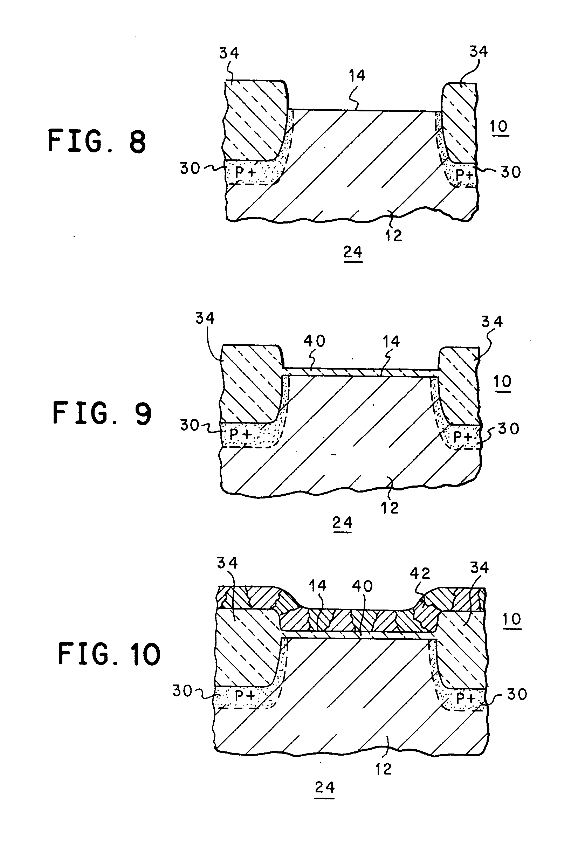

Next, the oxide layer 38 is etched away to produce the structure of FIGURE 8. It will be appreciated by those skilled in the art that good surface conditions are important to the operation of field-effect device elements, and particularly in the channel of an enhancement mode FET. In accordance with the present invention, the oxidizing and etching steps of FIGURES 7 and 8 are effective to remove surface damage (generally occurring in the top 20 to 30 Angstoms of the substrate 12) as well as the silicon nitride contamination, thereby providing the clean, impurity-free surface portions 14 shown in FIGURE 8.

As a result of the successive etching steps to remove oxide layers 16, 28, and 38, in the steps shown from FIGURE 5 through FIGURE 8, the field oxide 34 is somewhat reduced in thickness. At the process stage shown in FIGURE 8, the field oxide has an overall thickness of about 10,000 Angstroms, with about 7000 Angstroms extending to a level below the surface 14 and about 3000 Angstroms extending above the level of surface 14.

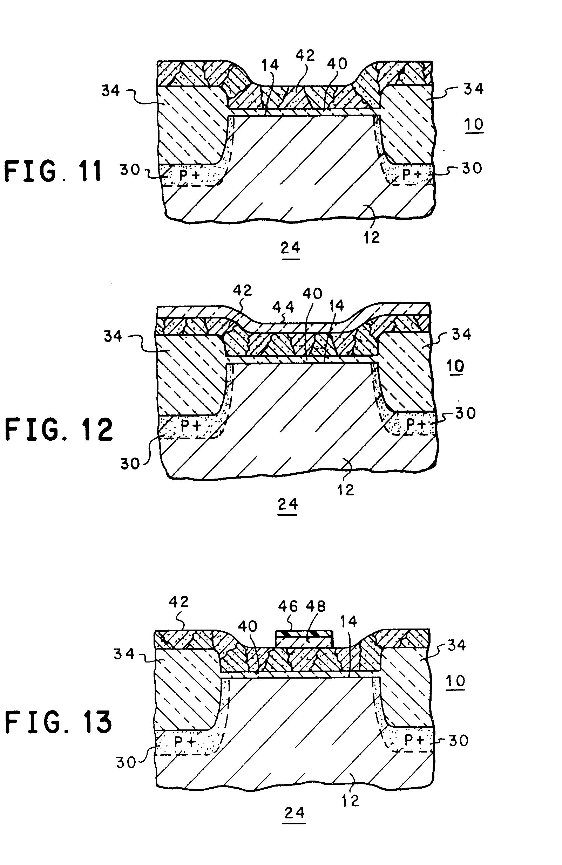

Next, thermal oxide layer 40 is grown to a thickness of about 900 Angstroms as shown in FIGURE 9. Now referring to FIGURE 10, a polysilicon layer 42 is deposited as shown over the entire device 10 to a thickness of about 6000 Angstroms using known techniques. In order to make layer 42 become highly conductive, it is then heavily doped N-type, preferably using phosphorus diffusion as represented by the stippling of polysilicon layer 42 in FIGURE 11.

Next, a top portion 44 of layer 42 is oxidized to produce the structure shown in FIGURE 12. Polyoxide layer 44 has a preferred thickness between about 2500 and 5000 Angstroms, the formation of which causes a corresponding reduction in the thickness of polysilicon layer 42 to between about 3500 and 4800 Angstroms. It is presently preferred, however, that layers 42 and 44 both be about 4000 Angstroms thick.

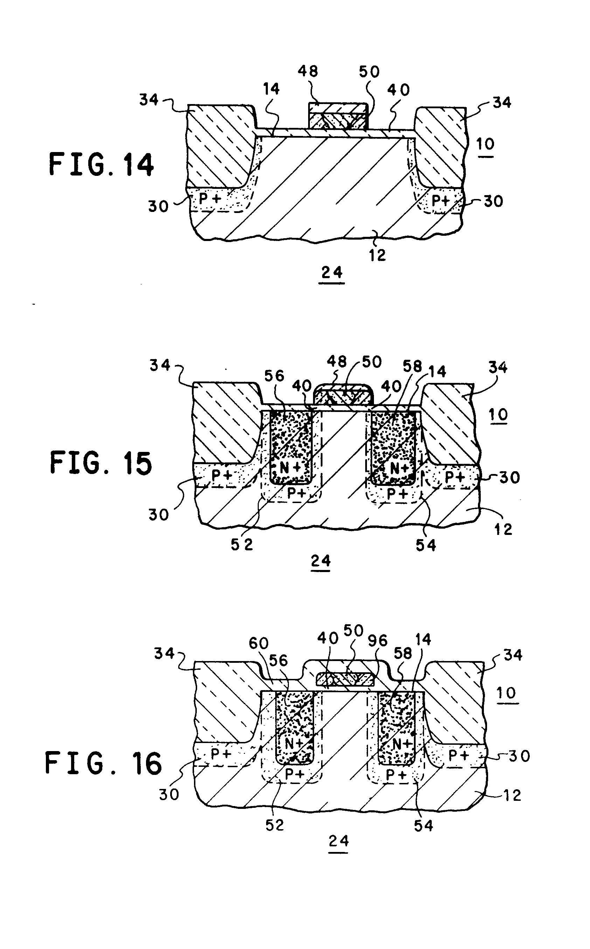

FIGURE 13 illustrates device 10 after masking and etching steps have been performed wherein photoresist pattern 46 is formed, and the portions of polyoxide layer 44 not covered by photoresist are etched away leaving polyoxide portion 48. Now referring to FIGURE 14, the photoresist has been removed leaving the polyoxide layer portion 48 as a mask for etching away portions of polysilicon layer 42. At similar sites of the device 10 of which site 24 is representative, similar polyoxide masks also exist so that etching produces a plurality of separate polysilicon layers in the device 10 of which layer 50 is representative. Note that layer 50 could similarly be formed of molybdenum or tungsten. Polysilicon layer 50 overlies a central portion of thermal oxide layer 40 in the element site 24 as shown in FIGURE 14.

The use of polyoxide portion 48 as a mask for etching the underlying polysilicon has an advantage over deposited oxide mask in that polyoxide growth produces a highly regular layer having a slower, more controllable etch rate. Such properties of polyoxide enable a high degree of mask definition to be carried through from the photoresist mask (layer 46 in FIGURE 13) to the polyoxide mask (layer 48 in FIGURE 14). The high degree of mask definition is further carried through in the formation of polysilicon layer 50. "High definition" means "positioned with a higher degree of precision" compared to prior art techniques using deposited oxide mask. The polysilicon layer 50 will be seen later in the process to further serve as a mask for etching the underlying oxide layer, thereby aligning itself over a channel region of a field-effect transistor. The technique of using a polysilicon layer as a mask for producing a self-aligned gate FET is known, the structure also being referred to in the art as a "silicon-gate" FET. The precision (or tolerance) in positioning layer 50 has a direct bearing on the degree of element density capable of formation in the integrated circuit device 10.

Next, a P-type dopant, preferably boron, implanted using known techniques enters the substrate 12 on either side of the polysilicon layer or conductive gate 50 with a surface concentration about $10^{13}$ atoms per $cm^2$. Thereafter, the P-type dopant is diffused in the substrate 12 using known techniques whereby $P^+$ regions 52 and 54 having an impurity concentration of between $10^{15}$ atoms per $cm^3$ and $10^{17}$ atoms per $cm^3$ are produced to a depth of about 2000 to 8000 Angstroms below surface 14 in accordance with the structure of FIGURE 15. A lateral diffusion is similarly obtained. Next an ion implantation of an N-type dopant, at about $10^{16}$ atoms per $cm^2$, preferably arsenic, is performed using known techniques. A diffusion step is then performed producing $N^+$ regions 56 and 58 having an impurity concentration above $10^{19}$ atoms per $cm^3$ in the substrate 12, to a depth of about 3000 Angstoms below surface 14 and within the $P^+$ regions 52 and 54 in accordance with the structure of FIGURE 15. This occurs because the arsenic does not diffuse as far into the substrate due to its low diffusion coefficient. In this manner the boron diffuses out around the $N^+$ arsenic junctions to form a P-type halo. In an alternative embodiment using an N-type substrate, different conductivity types would be used at this stage to produce the complementary conductivity-type structure of that shown herein.

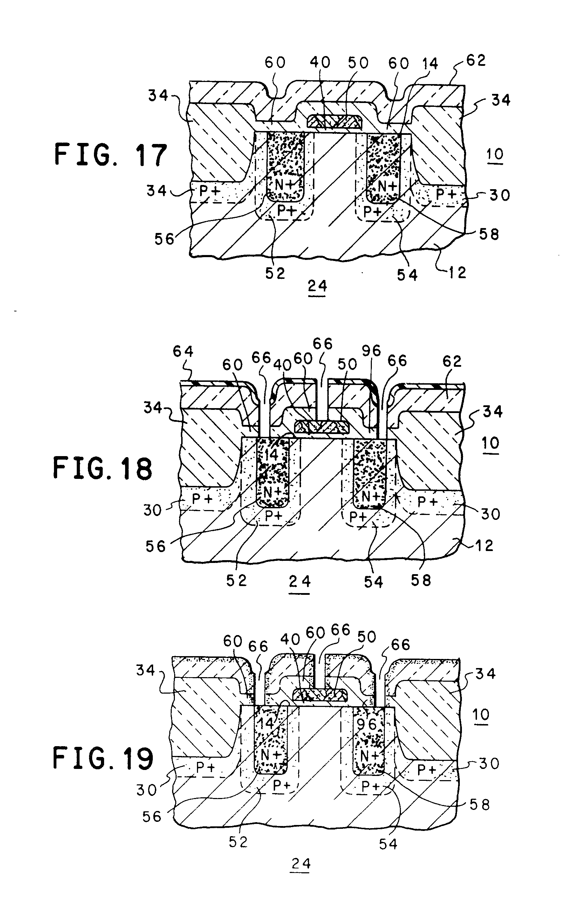

Now referring to FIGURE 16, the device 10 is placed in a furnace with dry oxygen or steam at about $900^{\circ}C$ to $1000^{\circ}C$ so that oxide layers of about 2000 Angstoms are grown over the devices indicated by the numeral 60. Further referring to FIGURE 17, and layer 62 "high temperature" undoped oxide is deposited, preferably using $SiH_2Cl_2$ and $N_2O$ in a known manner, at a temperature between $600^{\circ}C$ and $1000^{\circ}C$ to a thickness of preferably about 6000 Angstroms. At a corresponding stage, prior art processes typically deposit a "low temperature" oxide in a range of $350^{\circ}C$ to $450^{\circ}C$, which has a relatively fast etch rate causing extensive undercutting problems, but here an undoped oxide layer 62 is deposited which has an etch rate comparable to that of the underlying grown oxide layer 60. Most preferably, oxide layer 62 is deposited by placing the device 10 in a conventional furnace and heating the device to about $900^{\circ}C$ or $950^{\circ}C$ to cause the reaction: $SiH_2Cl_2 + 2N_2O \rightarrow SiO_2 + HCl + 2N_2$. Further, it will be appreciated that layer 62 is a redundant oxide layer which covers possible defects such as "pin holes" in the underlying oxide layer 60.

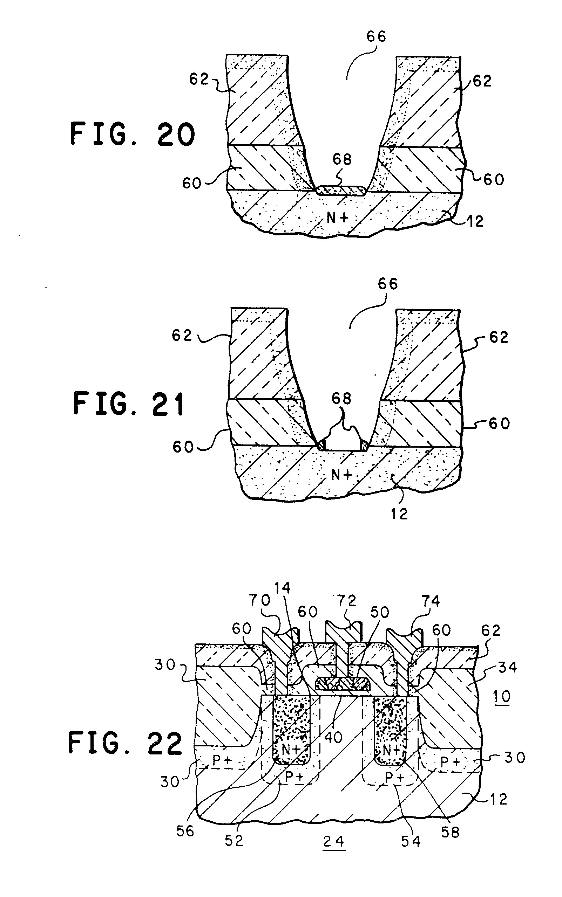

A photoresist mask 64 is then formed over deposited oxide layer 62. Next, contact windows 66 are opened by etching through the portions of oxide layer 26 not covered by photoresist mask 64, and continuing to etch down through the underlying oxide layer 60 as shown in FIGURE 18. Next, the photoresist layer 64 is removed, and a stabilization step is performed, preferably using a phosphorus diffusion, as indicated by the stippling along the exposed oxide surfaces shown in FIGURE 19 and the enlarged view of FIGURE 20. The phosphorus stabilization has the effect of producing very thin oxide layers 68 on exposed silicon surfaces (explicitly shown by way of example in FIGURE 20) which are approximately 20 to 100 Angstoms thick. It is convenient to getter the device 10 concurrently with stabilization, which may be achieved by covering all but the backside (i.e., the bottom surface of the substrate 12 with oxide thereon, not shown) with photoresist after opening windows 66, then stripping the backside down to clean silicon. Stabilization then proceeds as described in the preceding paragraph by removing the photoresist and exposing the device 10 to a phosphorus diffusion, which getters metallic impurities to the backside thereby favorably reducing leakage current.

After the phosphorus stabilization step it is necessary to reopen contact windows 66 through oxide layers 68. A photoresist layer (not shown) is reapplied using the same mask registration which produced layer 64. Then, oxide layers 68 are etched through to the underlying silicon to reopen the contact windows 66, and the photoresist is removed to produce windows 66 typically illustrated by FIGURE 21. The window opening 66 at surface 14 shown in FIGURE 21 may be controlled to less than 5 microns in diameter.

Finally, a metallization process is used to form contacts 70, 72, and 74 in the windows 66 which yields the device structure 10 shown in FIGURE 22. The contacts are preferably formed by vacuum deposition of aluminum, photomasking portions of the aluminum, and etching the unmasked portions with etchants which selectively attack the aluminum but not the underlying oxide layer 62. A metal oxide semiconductor transistor structure has thereby been constructed.

In particular, the element 24 is an N-channel enhancement mode FET having a self-aligned silicon gate similar to that which is described in Mai et al, cited above, wherein contact 72 serves as a gate contact to silicon gate 50 and contacts 70 and 74 serve as source and drain contacts to regions 56 and 58. The present invention may also be applied to make N-channel depletion mode FETs as well as both modes of P-channel FETs by modification of the process steps specifically recited herein in accordance with the teachings of Mai et al. In accordance with this invention, a smaller geometry with a channel region from about 3.0 microns to as small as about .5 microns is achieved without increasing body effect and parasitic capacitance. This is achieved by the use of the double implantation and diffusion providing a high impurity buffer region within the structure of the present invention. The substrate concentration does not have to be increased and the gate oxide may maintain its normal thickness. Further, accuracy of the channel length becomes less critical due to the effect of the impurity halos.

Although a preferred embodiment of the invention has been described in detail, it is to be understood that various changes, substitutions and alterations can be made therein without departing from the spirit and scope of the invention as defined by the appended claims.

CLAIMS

1.   A metal oxide semiconductor transistor structure comprising:

a semiconductor substrate (12) of a first conductivity type;

a first insulating layer (40) on a major surface of the semiconductor substrate;

two first regions (52, 54) of the first conductivity type disposed in the substrate (12) and doped more heavily than the substrate;

two second regions (56,58) of a second conductivity type, each disposed in the substrate within a first region and doped more heavily than the first region;

a channel region of the first conductivity type disposed in the substrate (12) between the second regions (56,58) and including a portion of the first regions (52,54); and

a conductive gate (50) disposed on the insulating layer (40) and aligned over the channel region due to the placement of the first (52,54) and second (56,58) regions.

2.   The metal oxide semiconductor transistor structure of Claim 1 wherein the conductive gate (50) is polycrystalline silicon.

3.   The metal oxide semiconductor transistor structure of Claim 1 wherein the conductive gate (50) is molybdenum.

4.   The metal oxide semiconductor transistor structure of Claim 1 wherein the conductive gate (50) is tungsten.

5.    The metal oxide semiconductor transistor
structure of Claim 1, 2, 3 or 4 further comprising
channel stop regions (30) of the first conductivity
type whereby that transistor structure is substantially
isolated from other transistor structures on the same
semiconductor substrate.

6.    The metal oxide semiconductor transistor
structure of any preceeding Claim wherein the conductive
gate (50) is covered by a second insulating layer (62).

7.    The metal oxide semiconductor transistor
structure of any preceding Claim wherein the first insulating layer (40) is substantially thicker beyond the
active area of the structure.

8.    The metal oxide semiconductor transistor
structure of any preceding Claim wherein the first (52,54)
and second (56,58) regions are formed by ion implantation.

9.    The metal oxide semiconductor transistor
structure of any preceding Claim wherein the first conductivity type is boron and the second conductivity type is
arsenic.

10.    The metal oxide semiconductor transistor
structure of any one of Claims 1 to 8 wherein the first
conductivity type is boron and the second conductivity
type is antimony.

11.    The metal oxide semiconductor transistor

14.

structure of any preceding Claim as dependent on Claim 5 wherein the first insulating layer (40) is substantially thicker over the channel stop regions (34).

12. A metal oxide semiconductor transistor structure comprising:

a semiconductor substrate (12) of a first conductivity type having an impurity concentration of below $3 \times 10^{15}$ atoms per $cm^3$;

a first insulating layer (40) disposed on a major surface of the semiconductor substrate;

two first regions (52,54) of the first conductivity type disposed in the substrate (12) and having an impurity concentration of between $10^{15}$ atoms per $cm^3$ and $10^{17}$ atoms per $cm^3$;

two second doped regions (56,58) of a second conductivity type each disposed in the substrate (12) within a first region and having an impurity concentration above $10^{19}$ atoms per $cm^3$;

a channel region of the first conductivity type disposed in the substrate (12) between the second regions (56,58) and including portions of the first regions (52,54); and

a conductive gate (50) disposed on the insulating layer (40) and aligned over the channel region.

13. The metal oxide semiconductor transistor structure of Claim 12 wherein the first region (52,54) extends beyond the second region (56,58) less than about 5000 Angstroms.

14. The metal oxide semiconductor transistor structure of Claim 12 or 13 wherein the length of the channel region is less than about 3.0 microns.

15. A method for making a metal oxide semiconductor transistor structure comprising the steps of:

providing a semiconductor substrate (12) of a first conductivity type;

forming a first insulating layer (16) of silicon dioxide on an active surface of the substrate;

forming second insulating layer (18) of silicon nitride on the first insulating layer;

placing a photoresistive mask (26) over the second insulating layer to define selected areas;

removing said selected areas of the photoresistive mask by a photographic technique to expose the second insulating layer below the selected area;

etching the exposed areas of the second insulating layer;

implanting ions of the first conductivity type through the exposed regions (30);

growing thick oxide regions (34) over the implanted regions;

removing the remaining second insulating layer;

removing the first insulating layer;

growing a thin oxide insulating layer (40);

depositing a polysilicon layer (42) on a thin oxide insulating layer;

removing portions of the polysilicon layer to define a conductive gate (50);

implanting ions of the first conductivity type in the areas between the conductive gate (50) and thick oxide regions (34);

diffusing the implanted ions to form first regions (52,54);

implanting ions of a second conductivity type in the same areas between the conductive gate (50) and thick oxide regions (34); and

diffusing the implanted ions of the second conductivity type to form second regions (56,58) within the first regions (52,54).

16.  A method for making a metal oxide semiconductor transistor structure comprising steps of:

forming a thin oxide insulating layer (40) over a semiconductor substrate (12);

defining a conductive gate (50) on the insulating layer;

forming first regions (52,54) of a first conductivity type on both sides of the conductive gate (50); and

forming second regions (56,58) of a second conductivity type within the first regions (52,54).

17.  The method for making a metal oxide semiconductor transistor structure of Claim 16 wherein the first and second regions are formed by ion implantation.

18.  The method for making a metal oxide semiconductor transistor structure of Claim 16 wherein the first region is formed by the ion implantation of boron and the second region is formed by the ion implantation of arsenic.

19.   The method for making a metal oxide semiconductor transistor structure of Claim 16 wherein the
first region is formed by the ion implantation of boron
and the second region is formed by the ion implantation
of antimony.

20.   A method for making a metal oxide semiconductor
transistor structure comprising the steps of:
        defining an active area in a semiconductor substrate
(12) of a first conductivity type;
        growing an insulating oxide layer (40) over the
active area;
        forming a conductive gate (50) over the insulating
layer;
        forming first (52,54) and second (56,58) regions
of different conductivity types on both sides of the
conductive  gate (50), the second regions (56,58) being
disposed within the first regions (52,54) whereby a
source and drain are formed.

FIG. 1

FIG. 2

FIG. 3

FIG. 4

FIG. 5

FIG. 6

FIG. 7

FIG. 8

FIG. 9

FIG. 10

FIG. 11

FIG. 12

FIG. 13

FIG. 14

FIG. 15

FIG. 16

FIG. 17

FIG. 18

FIG. 19

FIG. 20

FIG. 21

FIG. 22

| | DOCUMENTS CONSIDERED TO·BE RELEVANT | | CLASSIFICATION OF THE APPLICATION (Int. Cl.3) |
|---|---|---|---|
| Category | Citation of document with indication, where appropriate, of relevant passages | Relevant to claim | |
| X | US − A− 4 091 405 (NIPPON TELEGRAPH AND TELEPHONE PUBLIC CORP.) <br> * claims 1 and 2; column 2, lines 22 to 47; column 7, lines 4 to 65; fig. 1 and 2 * <br> & DE − A1 − 2 636 369 <br> −− | 1,12, 14 | H 01 L 29/78 <br> H 01 L 21/18 <br> H 01 L 29/08 |
| | FR − A1 − 2 330 146 (INTEL) <br> * page 7, line 26 to page 8, line 5; fig. 5 to 7 * <br> −− | 1,2, 16,20 | **TECHNICAL FIELDS SEARCHED (Int.Cl.3)** |
| A | DE − A1 − 2 615 441 (INTEL) <br> * claims 2 and 6; pages 10 to 16; fig. 3a to 3e, 4a to 4e, 6 * <br> −− | 2,5,7, 15,16, 20 | H 01 L 21/18 <br> H 01 L 29/08 <br> H 01 L 29/76 |
| A | IBM TECHNICAL DISCLOSURE BULLETIN, Vol. 16, No. 5, October 1973 New York <br> C.S. CHANG et al. "High-voltage FET integrated circuit process" pages 1635 to 1636 <br> * pages 1635 to 1636 * <br> −−−− | 15 | |

CATEGORY OF CITED DOCUMENTS

X: particularly relevant
A: technological background
O: non-written disclosure
P: intermediate document
T: theory or principle underlying the invention
E: conflicting application
D: document cited in the application
L: citation for other reasons

&: member of the same patent family, corresponding document

| The present search report has been drawn up for all claims | | |
|---|---|---|
| Place of search <br> Berlin | Date of completion of the search <br> 27-02-1980 | Examiner <br> ROTHER |

EPO Form 1503.1 06.78